Europäisches Patentamt

European Patent Office

Office européen des brevets

(11) Veröffentlichungsnummer: **0 470 559 A1**

## (12) EUROPÄISCHE PATENTANMELDUNG

(21) Anmeldenummer: **91113149.8**

(22) Anmeldetag: **05.08.91**

(51) Int. Cl.5: **H01L 23/31**, H01L 21/56

(30) Priorität: **07.08.90 DE 4025050**

(43) Veröffentlichungstag der Anmeldung:
**12.02.92 Patentblatt 92/07**

(84) Benannte Vertragsstaaten:
**DE FR GB IT NL**

(71) Anmelder: **SIEMENS AKTIENGESELLSCHAFT
Wittelsbacherplatz 2
W-8000 München 2(DE)**

(72) Erfinder: **Melbert, Joachim, Dr.-Ing.
Hinteres Gleissental 23b
W-8024 Deisenhofen(DE)**

(54) Verfahren zur Montage von integrierten Halbleiterschaltkreisen.

(57) Bei einem Verfahren zur Montage von integrierten Halbleiterschaltkreisen, bei dem das Schaltkreissystem (2) mit seinen Leitern (3) durch einen aushärtbaren Kunststoff abgedeckt ist, wird dieser zunächst als geschlossener Ring (6-1) aufgebracht und der das Halbleitersystem (2) und die Leitern (4) enthaltende Ring-Innenraum mit weiterem Kunststoff (6-2) aufgefüllt.

FIG 2

Die vorliegende Erfindung betrifft ein Verfahren zur Montage von integrierten Halbleiterschaltkreisen nach dem Oberbegriff des Patentanpruches 1.

Unter dem Begriff "Filmmontage" werden im Rahmen vorliegender Erfindung generell Bauformen verstanden, bei denen Schaltkreissysteme in einem Verbund mit einer Trägerfolie bzw. einem Film montiert werden und zwischen Anschlußstellen, sog. Pads auf dem Schaltkreissystem und Leiterbahnen auf der Trägerfolie, die zur Schaffung eines elektrischen Anschlusses nach außen dienen, eine Verbindung durch elektrische Leiter hergestellt wird.

Bei einer solchen Bauform kann es sich beispielsweise um die sog. Mikropack-Bauform handeln, wie sie etwa in der Siemens-Firmenschrift "Mikropack eine kompakte IC-Bauform", Dez. 1985, beschrieben ist. Grundsätzlich werden bei einer derartigen Bauform Schaltkreissysteme mit lötfähigen Hökern (Pads) in Trägerfolien bzw. Filmbändern mit verzinnten Kupferleitbahnen derart montiert, daß das Schaltkreissystem freitragend an Enden von Kupferleitbahnen in einem in der Trägerfolie befindlichen Fenster montiert ist. In diesem Fenster werden das Schaltkreissystem und mindestens die Verbindungsstellen der Leiterbahnen und der Pads auf dem Schaltkreissystem zum mechanischen Schutz mit einer Abdeckung aus aushärtbarem Kunststoff versehen.

Das Schaltkreissystem muß jedoch nicht notwendig in einem Fenster der Trägerfolie freitragend montiert sein. Es können auch Leiterbahnen auf einer durchgehend geschlossenen Trägerfolie vorgesehen sein und dabei das Schaltkreissystem mit seinen Pads auf die Leiterbahnen aufgesetzt sein (sog. Flip-Chip-Technik).

Weitere Möglichkeiten einer solchen Filmmontage bestehen beispielsweise darin, daß auf einem Filmband Leiterbahnen vorgesehen sind und die Verbindung zwischen diesen Leiterbahnen und den Pads auf dem Schaltkreissystem durch Kontaktierungsdrähte geschaffen wird.

Die Anordnung kann dabei so getroffen sein, daß die Leiterbahnen und das Schaltkreissystem auf der gleichen Seite der Trägerfolie vorgesehen sind, oder daß die Leiterbahnen einerseits und das Schaltkreissystem andererseits auf sich gegenüberliegenden Seiten der Trägerfolie vorgesehen sind und die elektrische Verbindung mittels der Kontaktierungsdrähte durch in der Trägerfolie vorgesehene Löcher erfolgt.

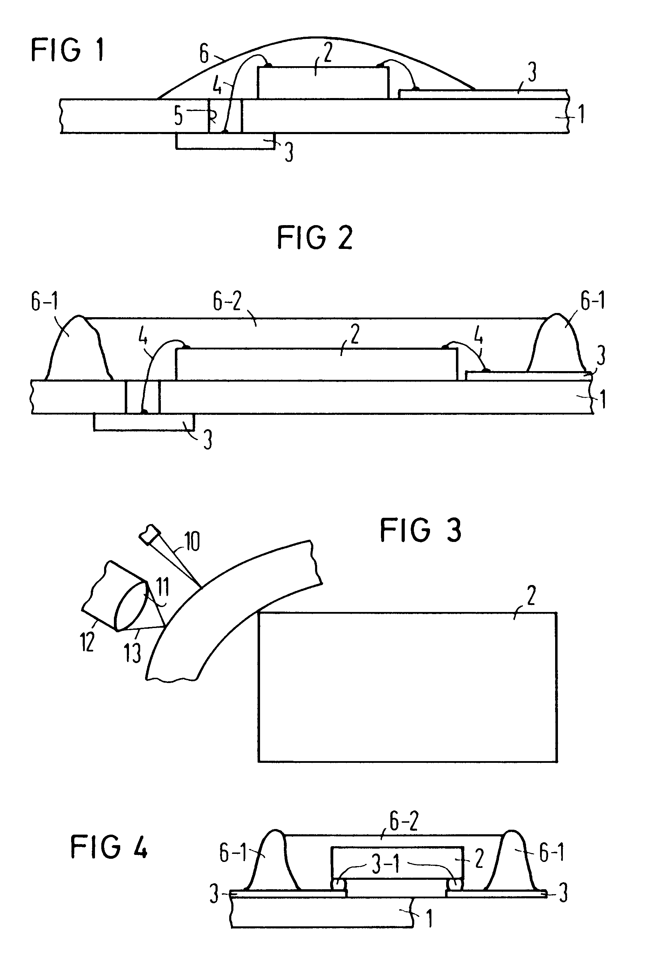

Eine Ausführungsform eines filmmontierten integrierten Halbleiterschaltkreises der letztgenannten Art ist schematisch in FIG 1 dargestellt. Dabei wird auf eine Seite einer isolierenden Trägerfolie 1 ein Schaltkreissystem 2 aufgebracht. Unter Schaltkreissystem wird dabei der die Funktionseinheiten einer integrierten Schaltung enthaltende Halbleiterkristall mit darauf vorgesehenen Leiterbahnen zur elektrischen Verbindung der Funktionseinheiten sowie Anschlußpads für eine Außenkontaktierung verstanden. Entweder auf der dem Schaltkreissystem 2 abgewandten Seite der Trägerfolie 1 oder auf der gleichen Seite sind als Außenanschlüsse für das Schaltkreissystem 2 dienende Leiterbahnen 3 vorgesehen. Für den erstgenannten Fall sind in der Trägerfolie an den Stellen der Leiterbahnen 3 Öffnungen bzw. Löcher 5 vorgesehen, durch die mittels Kontaktierungsdrähten 4 eine Kontaktierung von nicht eigens dargestellten Anschlußpads auf dem Schaltkreissystem 2 zu den Leiterbahnen 3 erfolgt. Im zweitgenannten Fall, in dem Schaltkreissystem 2 und Leiterbahnen 3 auf der gleichen Seite der Trägerfolie 1 vorgesehen sind, sind die Kontaktierungen ebenfalls mittels Kontaktierungsdrähten 4 durchgeführt. Es sei darauf hingewiesen, daß in FIG 1 die beiden genannten Möglichkeiten der Einfachheit halber nebeneinander dargestellt sind. In der Praxis wird es sich jedoch um getrennte Ausführungen handeln.

Zum Schutze des Schaltkreissystems 2 sowie der zur Kontaktierung dienenden Kontaktierungsdrähte 4 ist auf der Schaltkreissystem-Seite der Trägerfolie 1 eine Abdeckung 6 aus einem aushärtbaren Schutzlack vorgesehen. Diese Abdeckung wird gewöhnlich in Form eines Tropfens aus Schutzlack in der dargestellten Weise aufgebracht, der das Schaltkreissystem 2, die Kontaktierungsdrähte 4 und - in dem einen der beiden obengenannten Fälle die durchgehenden Löcher 5 auffüllt und - beispielsweise mittels UV-Strahlung ausgehärtet wird.

Mit zunehmender Größe der Schaltkreissysteme wird die vollständige Abdeckung zum Schutze des Schaltkreissystems und seiner Kontaktierungsdrähte schwieriger. Es muß entweder sehr viel Schutzlack aufgebracht werden, so daß sich stark überhöhte Abdeckungen 6 ergeben, oder es besteht die Gefahr, daß Schaltkreissystem 2 und Kontaktierungsdrähte 4 nicht vollständig abgedeckt werden, wodurch die mechanische Unzerstörbarkeit nicht mehr gewährleistet ist. Es kann zwar daran gedacht werden, bei Aufbringung einer ausreichend großen Menge von Schutzlack die Überhöhungen der Abdeckungen 6 abzuschleifen, was aber wiederum aus herstellungstechnischen Gründen unzweckmäßig ist.

Ein dazu generell besser geeignetes Verfahren der gattungsgemäßen Art ist aus der PCT-A-WO 89/00337 bekannt geworden. Dieses bekannte Verfahren ist primär für die Einkapselung von Dickfilm-Hybridschaltungenvorgesehen. Das Hauptaugenmerk ist dabei auf vorgebbare Festlegung des Außenumfangs der Einkapselung, möglichst schnelle Aushärtbarkeit des Einkapselungsmaterials und Maßgenauigkeit bei der Einkapselung von kleinen direkt gepackten Hybridschaltungen gelegt. Dazu wird nach dem bekannten Verfahren vorgeschlagen, für die Einkapselung ein durch Strahlung enthärtbares Material zu verwenden.

Dabei besteht jedoch ein Problem darin, daß bei zu weicher Abdeckmasse und großen Schaltkreissystemen Systembrüche auftreten können. Dies kann dadurch verhindert werden, daß ein das Schaltkreissystem umgebender Metall- oder Kunststoffrahmen vorgesehen wird.

Besitzt die Abdeckmasse eine zu hohe Stabilität, so übt sie eine mechanische Belastung auf die Systemoberfläche und die Funktionselementstrukturen aus, was zu Veränderungen des elektrischen Verhaltens führen kann.

Der vorliegenden Erfindung liegt die Aufgabe zugrunde, ein Verfahren der in Rede stehenden Art anzugeben, mit dem mechanische Festigkeit des Schaltkreises sowie Spannungsfreiheit des Schaltkreissystems gewährleistet sind.

Diese Aufgabe wird bei einem Verfahren der eingangs genannten Art erfindungsgemäß durch die Merkmale des kennzeichnenden Teils des Patentanspruches 1 gelöst.

Weiterbildungen der Erfindung sind Gegenstand von Unteransprüchen.

Die Erfindung wird im folgenden anhand von in den FIG 2 und 4 der Zeichnung dargestellten Ausführungsbeispielen näher erläutert. Es zeigt:

FIG 2     eine der FIG 1 entsprechende schematische Darstellung mit einer erfindungsgemäßen Schutzlackabdeckung;

FIG 3     eine schematische Draufsicht eines filmmontierten Halbleiterschaltkreises nach FIG 2 zur Erläuterung der Herstellung eines das Schaltkreissystem und seine Kontaktierungsdrähte umgebenden Schutzlackrings; und

FIG 4     eine Ausführungsform in der Flip-Chip-Montagetechnik.

In FIG 2, in der gleiche Teile wie in FIG 1 mit gleichen Bezugszeichen versehen sind, wird zur Abdeckung des Schaltkreissystems 2 sowie der Kontaktierungsdrähte 4 zunächst ein Kunststoffring 6-1 aufgebracht, der das Schaltkreissystem 2 und die Kontaktierungsdrähte 4 vollständig umschließt. Dieser Kunststoffring 6-1 wird dabei in einer Höhe auf die Trägerfolie 1 aufgebracht, daß er über das Halbleitersystem 1 und die Kontaktierungsdrähte 4 hinausreicht. Die Höhe dieses Kunststoffrings 6-1 ist dabei so festgelegt, daß bei einer nachfolgend noch zu erläuternden vollständigen Verschließung mit weiterem Kunststoff 6-2 das Schaltkreissystem 2 und die Kontaktierungsdrähte 4 einerseits sicher abgedeckt sind und sich andererseits keine nachteilige starke Überhöhung der Gesamtabdeckung ergibt.

Wie in FIG 3 schematisch dargestellt ist, kann der Kunststoffring 6-1 in der Weise aufgebracht werden, daß eine Düse 10 um das Schaltkreissystem 2 herumgeführt und dabei im wesentlichen gleichzeitig eine Aushärtung mittels einer UV-Lichtquelle erfolgt, die schematisch durch eine Linse 11 und Strahlengänge 12,13 vor bzw. hinter der Linse dargestellt ist.

Der durch den Kunststoffring 6-1 umschlossene Innenraum, der das Schaltkreissystem 2 und die Kontaktierungsdrähte 4 enthält, wird sodann mit weiterem Kunststoff 6-2 aufgefüllt, so daß sich eine im wesentlichen ebene Gesamtabdeckung aus Kunststoffring 6-1 und weiterem Kunststoff 6-2 ergibt.

Es kann zweckmäßig sein, für den Kunststoffring 6-1 und für den weiteren Kunststoff 6-2 aushärtbare Lacke unterschiedlicher Viskosität zu verwenden. Dabei ist es insbesondere zweckmäßig, für den Schutzlackring einen viskoseren Lack, der nach Aushärtung eine hohe mechanische Festigkeit besitzt und als aufzufüllenden Schutzlack 6-2 einen leicht fließenden Lack relativ geringer Viskosität zu verwenden, um eine im wesentlichen ebene Abdeckung, d.h. einen im wesentlichen rechteckförmigen Querschnitt, zu gewährleisten. Der weitere Schutzlack 6-2 wird in üblicher Weise, beispielsweise ebenfalls durch UV-Licht, ausgehärtet.

In Weiterbildung der Erfindung kann es zur Vermeidung von Brüchen des Schaltkreissystems 2 einerseits und von mechanischen Belastungen des Schaltkreissystems 2 andererseits zweckmäßig sein, nur für den Schutzlackring 6-1 einen mechanisch stabilen Lack und für den der Auffüllung dienenden Lack (6-2) einen weichen Lack zu verwenden.

Auch in FIG 2 sind entsprechend FIG 1 die beiden Möglichkeiten des Aufbringens der Leiterbahnen 3 gleichzeitig dargestellt.

Es sei noch einmal darauf hingewiesen, daß das erfindungsgemäße Verfahren für jede denkbare Art von filmmontierten integrierten Halbleiterschaltkreisen anwendbar ist, wie dies eingangs erläutert wurde.

So zeigt FIG 4, in der gleiche Teile wie in den vorhergehenden Figuren mit gleichen Bezugszeichen versehen sind, eine Auführungsform in Flip-Chip-Montagetechnik.

Auf der Trägerfolie 1 sind wiederum Leiterbahnen 3 vorgesehen, auf die das Schaltkreissystem 2 mit ihnen zugekehrten Anschlußpads aufgesetzt wird, so daß - beispielsweise durch Lötung gebildete - elektrische Verbindungen 3-1 entstehen.

Zu der Kunststoffabdeckung 6-1, 6-2 gelten im übrigen die vorstehenden Ausführungen entsprechend.

Um in FIG 4 eine Ausführungsform mit darzustellen, bei der die Trägerfolie 1 fehlt, ist auf der rechten Seite dieser Figur die Möglichkeit einer Montage gezeigt, bei der das Halbleitersystem 2 freitragend auf Leiterbahnen 3 kontaktiert ist. Auch für eine solche Montageform ist das erfindungsgemäße Verfahren geeignet.

**Patentansprüche**

1. Verfahren zur Montage von integrierten Halbleiterschaltkreisen, bei dem ein Schaltkreissystem (2) mit Leiterbahnen (3) zur Schaffung elektrischer Verbindungen des Schaltkreissystems (2) nach außen verbunden wird, bei dem das Schaltkreissystem (2) und wenigstens die Verbindung zwischen diesem Schaltkreissystem und den Leiterbahnen (3) mit einem aushärtbaren Kunststoff (6) abgedeckt werden, bei dem zunächst ein das Schaltkreissystem (2) einschließlich wenigstens der Verbindung zwischen dem Schaltkreissystem und den Leiterbahnen (3) geschlossen umgebender Kunststoffring (6-1) in einer über das Schaltkreissystem (2) und die Verbindung hinausreichenden Höhe aufgebracht wird und bei dem der das Schaltkreissystem (2) und die Verbindung enthaltende Kunststoff-Innenraum mit weiterem aushärtbaren Kunststoff (6-2) aufgefüllt wird, **dadurch gekennzeichnet,** daß für den Kunststoffring (6-1) ein nach Aushärtung mechanisch stabiler Lack und für den auffüllenden weiteren Lack (6-2) ein nach Aushärtung weicher Lack verwendet wird.

2. Verfahren nach Anspruch 1, **dadurch gekennzeichnet,** daß das Schaltkreissystem (2) an einer isolierenden Trägerfolie (1) montiert wird und die Leiterbahnen (3) im Verbund von Trägerfolie (1) und Schaltkreissystem (2) vorgesehen sind und daß der Kunststoffring (6-1) und der weitere aushärtbare Kunststoff (6-2) auf die Trägerfolie (1) aufgebracht werden.

3. Verfahren nach Anspruch 1 und/oder 2, **dadurch gekennzeichnet,** daß für den Kunststoffring (6-1) ein UV-aushärtbarer Lack mittels einer Düse (10) aufgebracht und im wesentlichen gleichzeitig mittels einer UV-Lichtquelle (11 bis 13) ausgehärtet wird.

4. Verfahren nach einem der Ansprüche 1 bis 3, **dadurch gekennzeichnet,** daß für den Kunststoffring (6-1) und den auffüllenden weiteren Kunststoff (6-2) Lacke unterschiedlicher Viskosität verwendet werden.

5. Verfahren nach einem der Ansprüche 1 bis 4, **dadurch gekennzeichnet,** daß als auffüllender Kunststoff (6-2) ein leicht fließender Lack relativ geringer Viskosität verwendet wird.

FIG 1

FIG 2

FIG 3

FIG 4

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | PATENT ABSTRACTS OF JAPAN vol. 11, no. 346 (E-556)(2793) 12 November 1987, & JP-A-62 125653 (MITSUBISHI ELECTRIC CORP) 06 Juni 1987, * das ganze Dokument * — — — | 1,4,5 | H 01 L 23/31 H 01 L 21/56 |
| Y | PATENT ABSTRACTS OF JAPAN vol. 11, no. 198 (E-519)(2645) 25 Juni 1987, & JP-A-62 025429 (NEC CORP) 03 Februar 1987, * das ganze Dokument * — — — | 1,4,5 | |
| A | FR-A-2 651 923 (AUTOMOBILES PEUGEOT) * Seite 2, Zeile 28 - Seite 5, Zeile 25; Figuren 1, 2 * — — — | 1,2 | |
| A | PATENT ABSTRACTS OF JAPAN vol. 11, no. 7 (E-469)(2454) 09 Januar 1987, & JP-A-61 184834 (TOSHIBA CHEM CORP) 18 August 1986, * das ganze Dokument * — — — | 1,3 | |
| A | CH-A-619 333 (FASELEC AG) * Seite 2, Zeile 41 - Seite 3, Zeile 27; Figuren 1, 2 * — — — — — | 1,3 | **RECHERCHIERTE SACHGEBIETE (Int. Cl.5)** H 01 L |

Der vorliegende Recherchenbericht wurde für alle Patentansprüche erstellt

| Recherchenort | Abschlußdatum der Recherche | Prüfer |
|---|---|---|
| Berlin | 09 Oktober 91 | LE MINH I |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
------------------------------------------------------------
& : Mitglied der gleichen Patentfamilie, übereinstimmendes Dokument